# EUROPÄISCHE PATENTSCHRIFT

(11) **EP 3 981 641 B1**
(45) Veröffentlichungstag und Bekanntmachung des Hinweises auf die Patenterteilung: **26.07.2023**
(21) Anmeldenummer: 21198407.5
(22) Anmeldetag: 23.09.2021
(51) Int. Cl.: B60L 53/302, B60L 53/30

(54) **KÜHLTANKANLAGE FÜR EINE FLÜSSIGKEITSKÜHLUNG EINER LADESTATION FÜR ELEKTRISCH ANTREIBBARE KRAFTFAHRZEUGE**
COOLING TANK SYSTEM FOR A LIQUID COOLING OF A CHARGING STATION FOR ELECTRICALLY DRIVEN VEHICLES
ENSEMBLE RÉSERVOIR DE REFROIDISSEMENT POUR UN REFROIDISSEMENT DE LIQUIDE D'UNE STATION DE CHARGE POUR VÉHICULES ÉLECTRIQUES

(30) Priorität: 08.10.2020 DE 102020126413
(43) Veröffentlichungstag der Anmeldung: 13.04.2022
(73) Patentinhaber: Dr.Ing. h.c. F. Porsche Aktiengesellschaft, 70435 Stuttgart (DE); Ads-tec Energy GmbH, 72622 Nürtingen (DE)
(72) Erfinder: HEYNE, Dr.-Ing. Raoul, 75446 Wiernsheim (DE); BOHNER, Matthias, 70376 Stuttgart (DE); SPEIDEL, Thomas, 71706 Markgröningen (DE)
(74) Vertreter: Sturm, Christoph

(56) Entgegenhaltungen:
- WO-A1-96/39561
- CA-A1- 2 321 808
- DE-A1-102017 217 879
- US-A- 4 911 326

## Beschreibung

Die Erfindung betrifft eine Kühltankanlage, mit deren Hilfe für eine Flüssigkeitskühlung einer Ladestation für elektrisch antreibbare Kraftfahrzeuge vorgesehenes flüssiges Kühlmedium unterirdisch gespeichert werden kann.

Aus DE 10 2017 217 879 A1 ist eine Ladestation zum Aufladen eines elektrisch antreibbaren Kraftfahrzeugs bekannt, deren Leistungselektronik mit Hilfe einer unterirdischen Flüssigkeitskühlung gekühlt werden kann.

CA 2 321 808 A1, WO 96/39561 A1, US 4 911 326 A und DE 10 2017 217 879 A1 offenbaren weiteren Stand der Technik.

Es besteht ein ständiges Bedürfnis eine Ladestation für elektrisch antreibbare Kraftfahrzeuge gut zu kühlen, ohne hierbei die Umwelt zu gefährden.

Es ist die Aufgabe der Erfindung Maßnahmen aufzuzeigen, die eine umweltsicherere und gute Kühlung einer Ladestation für elektrisch antreibbare Kraftfahrzeuge ermöglichen.

Die Lösung der Aufgabe erfolgt erfindungsgemäß durch eine Kühltankanlage mit den Merkmalen des Anspruchs 1. Bevorzugte Ausgestaltungen der Erfindung sind in den Unteransprüchen und der nachfolgenden Beschreibung angegeben, die jeweils einzeln oder in Kombination einen Aspekt der Erfindung darstellen können.

Eine Ausführungsform betrifft eine Kühltankanlage für eine Flüssigkeitskühlung einer Ladestation für elektrisch antreibbare Kraftfahrzeuge mit mindestens einem Speicherbehälter zur Aufnahme eines umweltgefährdenden Kühlmediums, einer Rückhaltewanne zum Zurückhalten einer Leckagemenge aus dem Speicherbehälter, wobei der Speicherbehälter in der Rückhaltewanne eingesetzt ist und zwischen Speicherbehälter und der Rückhaltewanne ein Aufnahmevolumen zur Aufnahme des gesamten Flüssigkeitsvolumens des Speicherbehälters ausgebildet ist, einer Außenwanne zur Abstützung von Erdlasten, wobei die Rückhaltewanne in der Außenwanne eingesetzt ist, einem in Schwerkraftrichtung zwischen der Rückhaltewanne und der Außenwanne in der Außenwanne vorgesehenen, insbesondere textilen, Absorptionskörper zur Aufnahme von Feuchtigkeit und einem Feuchtigkeitssensor zur Detektion der Feuchtigkeit des Absorptionskörpers.

Der insbesondere als ein textiles Vlies ausgestaltete Absorptionskörper kann Feuchtigkeit oder in die Außenwanne eintretende Flüssigkeit aufnehmen, so dass der Feuchtigkeitssensor an einer definierten Stelle gesammelte Feuchtigkeit messen kann. Hierbei ist es möglich sowohl eine Leckage von außen durch die Außenwanne hindurch als auch eine Leckage von der Rückhaltewanne in die Außenwanne zu detektieren. Eine Aufständerung der Rückhaltewanne in einer Betonwandung kann dadurch eingespart werden. Da in dem Zwischenraum zwischen der Rückhaltewanne und der Außenwanne infolge einer Leckage auftretende Feuchtigkeit in dem Absorptionskörper konzentriert werden kann, ist eine Sichtprüfung der Innenwand der Außenwanne und der Außenwand der Rückhaltewanne eingespart. Selbst eine sehr geringe Leckage, die bei einer Sichtprüfung kaum von kondensiertem Kondenswasser aus der Luftfeuchtigkeit unterschieden werden kann, kann durch die Ansammlung im Absorptionskörper detektiert werden. Insbesondere kann der zeitliche Verlauf der detektierten Feuchtigkeit in dem Adsorptionskörper gemessen werden, um das Vorliegen einer Leckage in einer mit dem Feuchtigkeitssensor verbundenen Auswerteeinheit sicher feststellen zu können. Gleichzeitig kann eine Leckage aus dem Speicherbehälter von der Rückhaltewanne vollständig zurückgehalten werden, so dass die Rückhaltewanne bereits einen doppelwandigen Schutz der Umwelt vor dem Kühlmedium bereitstellt, der durch die Außenwanne sogar dreiwandig ausgestaltet ist. Eine Leckage kann dadurch schnell und zuverlässig erkannt werden und lange genug zurückgehalten werden, bis eine Reparatur durchgeführt werden kann. Hierbei wird die Erkenntnis ausgenutzt, dass es bei einer unterirdisch verbauten Kühltankanlage einige Zeit dauern kann bis eine Leckage repariert werden kann, so dass mit der Außenwanne und der Überwachung der Feuchtigkeit in der Außenwanne eine weitere Sicherheitsinstanz gegen einen Austritt des Külmediums in die Umgebung geschaffen werden kann und auch eine besondere Dringlichkeit für die Durchführung einer Reparaturmaßnahme erkannt werden kann. Dies ermöglicht es in einem großen Umfang, beispielsweise über 220 Liter, eines gut kühlenden aber umweltgefährdenden, insbesondere wassergefährdenden, Kühlmediums beispielsweise ein Wasser/Glykol-Gemisch, in der Kühltankanlage bereitzuhalten, ohne dass eine Gefährdung der Umwelt durch das Kühlmedium erfolgen kann. Durch die Überwachung der Feuchtigkeit im Zwischenraum zwischen der Rückhaltewanne und der Außenwanne kann eine besondere Dringlichkeit für eine Reparaturmaßnahme rechtzeitig vor einer Kontaminierung der Umwelt durch das Kühlmedium erkannt werden, so dass eine umweltsicherere und gute Kühlung einer Ladestation für elektrisch antreibbare Kraftfahrzeuge ermöglicht ist.

Die Kühltankanlage kann insbesondere zumindest zu einem Großteil unterirdisch vorgesehen sein, indem die Kühltankanlage in einem Untergrund eingegraben ist. Die Außenwanne ist hierbei derart ausgestaltet, insbesondere ausgeformt, dass die von dem Erdreich auf die Außenwanne drückenden Lasten abgestützt werden können und nicht von der Rückhaltewanne abgestützt werden müssen. Eine unnötige Belastung der Rückhaltewanne, die zu einer Beschädigung der Wandung der Rückhaltewanne führen könnte, ist dadurch vermieden. Die Außenwanne und die Rückhaltewanne sind insbesondere aus einem dichtgeschweißten Stahl hergestellt. Vorzugsweise ist ein erster Speicherbehälter für gekühltes Kühlmedium und ein separater zweiter Speicherbehälter für ein erwärmtes Kühlmedium vorgesehen, so dass die Komponenten der Ladestation auf eine gewünschte Betriebstemperatur temperiert werden können. Zudem ist es möglich zwischen dem mindestens einen Speicherbehälter und der Rückhaltewanne und/oder zwischen der Rückhaltewanne und der Außenwanne ein Isoliermaterial, insbesondere zur thermischen Isolierung und/oder flüssigkeitsdichten Abdichtung vorzusehen. Das zwischen dem mindestens einen Speicherbehälter und der Rückhaltewanne ausgebildete Aufnahmevolumen entspricht insbesondere mindestens der Summe sämtlicher Innenvolumina der Speicherbehälter, so dass das gesamte installierte Volumen aller Kühlmedien von der Rückhaltewanne aufgenommen werden kann. Vorzugsweise entspricht das Volumen des Zwischenraums zwischen der Rückhaltewanne und der Außenwanne mindestens der Summe sämtlicher Innenvolumina der Speicherbehälter, so dass das gesamte installierte Volumen aller Kühlmedien von der Außenwanne aufgenommen werden kann, falls auch die Rückhaltewanne undicht werden sollte.

Insbesondere ist der Absorptionskörper an einer in Schwerkraftrichtung tiefsten Stelle eines Innenraums der Außenwanne und/oder über eine gesamte Bodenfläche der Außenwanne vorgesehen. Die in dem Zwischenraum zwischen der Rückhaltewanne und der Außenwanne auftretende Feuchtigkeit kann dadurch schwerkraftgetrieben zum Absorptionskörper gelangen, so dass schnell die gesamte Feuchtigkeit im Zwischenraum von dem Feuchtigkeitssensor gemessen werden kann.

Vorzugsweise ist die Außenwanne aus einem Stahl hergestellt, wobei die Außenwanne insbesondere Versteifungsrippen zur Abstützung von Erdlasten aufweist. Durch die Versteifungsrippen kann die Außenwanne leicht so stabil ausgestaltet werden, dass es nicht erforderlich ist eine Außenhülle aus Beton vorzusehen, in der die Kühltankanlage aufgeständert ist. Stattdessen kann die Kühltankanlage über die versteifte Außenwanne in direktem Kontakt mit dem Erdreich der Umgebung gelangen, ohne dass eine Verschmutzung der Umgebung durch austretendes Kühlmedium zu befürchten ist.

Besonders bevorzugt ist vorgesehen, dass ein aus der Außenwanne herausgeführtes Schaurohr zur optischen Untersuchung des Absorptionskörpers und/oder der Außenwanne und/oder der Rückhaltewanne an den Absorptionskörper heranreicht, wobei der Feuchtigkeitssensor durch das Schaurohr hindurch an den Absorptionskörper herangeführt ist. Durch das Schaurohr kann ein Endoskop oder sonstiges Prüfmittel in den Zwischenraum zwischen der Rückhaltewanne und der Außenwanne eingeführt werden, um eine optische Prüfung des Absorptionskörpers oder sonstige Prüfungen durchzuführen. Das hierzu vorgesehene Schaurohr kann zusätzlich dazu vorgesehen werden, den zur Messung der Feuchtigkeit in dem Absorptionskörper vorgesehene Feuchtigkeitssensor zu positionieren. Der Feuchtigkeitssensor kann dadurch für eine Prüfung und/oder Wartung leicht von dem Absorptionskörper weg durch das Schaurohr nach außen gezogen und über das Schaurohr wieder zurück in seine ursprüngliche Lage gebracht werden. Die Wartungs- und Prüfungsfreundlichkeit ist dadurch verbessert. Das Schaurohr kann einstückig ausgestaltet sein, wobei vorzugsweise das Schaurohr mehrteilig ausgebildet ist, beispielsweise indem ein Teil des Öffnungsquerschnitts des Schaurohrs durch eine offene Rinne ausgebildet ist, die auf einer Außenseite der Rückhaltewanne aufgesetzt ist, so dass der von der Rinne abgedeckte Teil der Außenseite der Rückhaltewanne den übrigen Öffnungsquerschnitt des Schaurohrs begrenzt. Der Materialeinsatz und der Bauraumbedarf für das Schaurohr kann dadurch gering gehalten werden.

Insbesondere weist der Speicherbehälter einen Füllstandssensor zur Detektion eines Füllstands des Kühlmediums in dem Speicherbehälter auf, wobei der Füllstandssensor mit einer Auswerteeinheit zum Vergleich des von dem Füllstandssensor gemessenen Füllstands mit einem ohne Leckage zu erwartenden Füllstand verbunden ist. Wenn der gemessene Füllstand deutlich geringer als der erwartete Füllstand ist, kann dies das Vorliegen einer Leckage indizieren. Die Auswerteeinheit kann dann die Durchführung einer Wartung veranlassen, beispielsweise indem die Auswerteeinheit das Absetzen einer entsprechenden Warnung an ein externes Service-Center veranlasst. Dadurch kann frühzeitig eine Wartung veranlasst werden, bevor eine Leckage in der Rückhaltewanne oder in der Außenwanne detektiert wird.

Vorzugsweise ist in der Rückhaltewanne ein weiterer Feuchtigkeitssensor und/oder ein weiterer Füllstandssensor zur Detektion einer Leckage aus dem Speicherbehälter in die Rückhaltewanne vorgesehen. Wenn in der Rückhaltewanne ein zu hoher Flüssigkeitsanteil detektiert wird, kann dies das Vorliegen einer Leckage indizieren. Eine mit dem weiteren Feuchtigkeitssensor und/oder mit dem weiteren Füllstandssensor verbundene Auswerteeinheit kann dann die Durchführung einer Wartung veranlassen, beispielsweise indem die Auswerteeinheit das Absetzen einer entsprechenden Warnung an ein externes Service-Center veranlasst. Wenn gleichzeitig keine Feuchtigkeit in dem Absorptionskörper im Zwischenraum zwischen der Rückhaltewanne und der Außenwanne detektiert ist, kann die in der Rückhaltewanne detektierte Feuchtigkeit mit einer sehr hohen Wahrscheinlichkeit nur durch eine Leckage des Speicherbehälters verursacht sein. Besonders bevorzugt ist in der Rückhaltewanne ein weiterer Absorptionskörper vorgesehen, der analog ausgestaltet und angebunden sein kann wie der Absorptionskörper in der Außenwanne.

Besonders bevorzugt ist mit dem Speicherbehälter eine Zulaufleitung zur Zuführung von Kühlmedium an mindestens eine zu kühlende Komponente der Ladestation und eine Rücklaufleitung zur Rückführung vom von der zu kühlenden Komponente kommenden Kühlmedium vorgesehen, wobei zum Ausschluss einer hydraulischen Heberwirkung in der Zulaufleitung ein Entlüftungsventil und/oder in der Rücklaufleitung ein Rückschlagventil vorgesehen ist. Durch das Entlüftungsventil kann Umgebungsdruck angelegt werden, so dass eine Heberwirkung aus dem Speicherbehälter in einer Saugleitung vermieden werden kann. Durch das Rückschlagventil kann eine Strömung entgegen der designierten Strömungsrichtung aus dem Speicherbehälter heraus automatisch vermieden werden. Eine Leckage von Kühlmedium über eine beschädigte Komponente der Ladestation infolge des hydrostatischen Hebereffekts kann dadurch vermieden werden.

Insbesondere ist in Schwerkraftrichtung oberhalb des Absorptionskörpers ein durch die Außenwanne und die Rückhaltewanne hindurchgeführtes doppelwandiges medienführendes Leitungsrohr vorgesehen, wobei das Leitungsrohr über ein Dichtelement, insbesondere einer Ringraumdichtung und/oder einer Gummipressdichtung, gegenüber der Außenwanne und der Rückhaltewanne abgedichtet ist. Dies ermöglicht es, das Leitungsrohr unterirdisch vorzusehen und ausreichend gegen Leckage zu sichern.

Vorzugsweise ist eine mit dem Feuchtigkeitssensor verbundene Auswerteeinheit zur Identifikation und/oder Quantifizierung einer Leckage in der Außenwanne und/oder in der Rückhaltewanne vorgesehen, wobei das Leitungsrohr einen Leckagesensor zur Detektion einer Leckage in dem Leitungsrohr aufweist und der Leckagesensor mit der Auswerteeinheit zur Identifikation einer Leckage und/oder einer Quantifizierung einer Leckage in dem Leitungsrohr verbunden ist. Die Auswertetechnik in der Auswerteeinheit kann dadurch nicht nur für die Außenwanne und/oder die Rückhaltewanne, sondern auch für das doppelwandige Leitungsrohr genutzt werden, so dass die Bauteileanzahl gering gehalten werden kann.

Eine weitere Ausführungsform betrifft eine Ladestation zum Aufladen eines elektrisch antreibbaren Kraftfahrzeugs mit einem Ladekabel zur Herstellung eines elektrischen Kontakts des Kraftfahrzeugs mit einer elektrischen Energiequelle, einer Leistungselektronik zur Steuerung eines Aufladevorgangs und einer Flüssigkeitskühleinrichtung zur Temperierung des Ladekabels und/oder der Leistungselektronik, wobei die Flüssigkeitskühleinrichtung eine zumindest zu einem Großteil unterirdisch vorgesehenen Kühltankanlage, die wie vorstehend beschrieben aus- und weitergebildet sein kann, zur Speicherung eines Kühlmediums aufweist. Durch die Überwachung der Feuchtigkeit im Zwischenraum zwischen der Rückhaltewanne und der Außenwanne der Kühltankanlage kann eine besondere Dringlichkeit für eine Reparaturmaßnahme rechtzeitig vor einer Kontaminierung der Umwelt durch das Kühlmedium erkannt werden, so dass eine umweltsicherere und gute Kühlung einer Ladestation für elektrisch antreibbare Kraftfahrzeuge ermöglicht ist.

Nachfolgend wird die Erfindung unter Bezugnahme auf die anliegende Zeichnung anhand eines bevorzugten Ausführungsbeispiels exemplarisch erläutert, wobei die nachfolgend dargestellten Merkmale sowohl jeweils einzeln als auch in Kombination einen Aspekt der Erfindung darstellen können. Es zeigt:

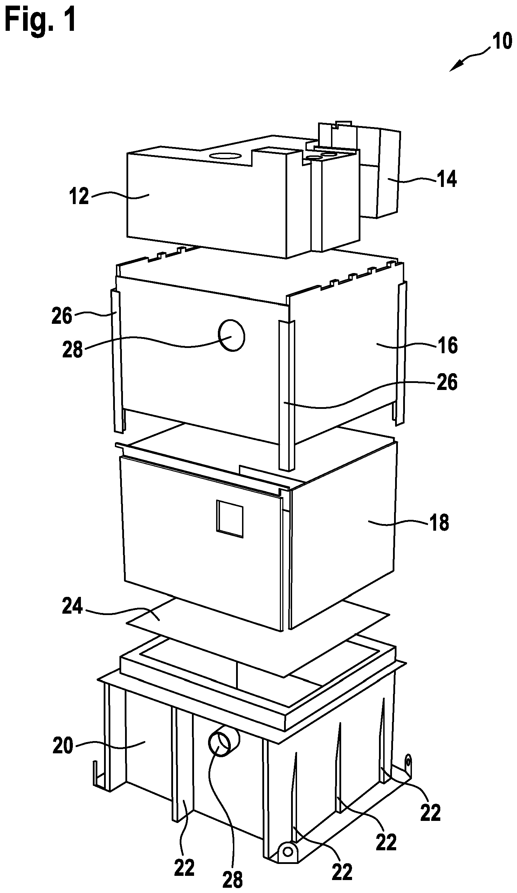

Fig. 1: eine schematische, perspektivische Explosionsdarstellung einer Kühltankanlage.

Die in Fig. 1 dargestellte Kühltankanlage 10 kann eine erhebliche Menge eines Kühlmediums speichern, das Komponenten in einer zum Aufladen elektrisch antreibbarer Kraftfahrzeuge vorgesehenen Ladestation auf eine gewünschte Betriebstemperatur temperieren kann. Insbesondere kann eine sich beim Laden erwärmende Leistungselektronik und/oder ein Ladekabel der Ladestation gekühlt werden. Hierzu kann die Kühltankanlage 10 einen Speicherbehälter 12 aufweisen, der beispielsweise zwischen 220 Liter und 1000 Liter eines Kühlmediums speichern kann. Es ist auch möglich einen weiteren Speicherbehälter 14 vorzusehen, in dem ein Kühlmedium bei einer anderen Temperatur gespeichert wird, so dass beispielsweise mit dem Kühlmedium in dem Speicherbehälter 12 gekühlt und mit dem Kühlmedium in dem weiteren Speicherbehälter 14 geheizt werden kann. Die Speicherbehälter 12, 14 sind, insbesondere vollständig, in einer Rückhaltewanne 16 eingesetzt, die aus den Speicherbehälter 12, 14 als Leckage austretendes Kühlmedium auffangen und zurückhalten kann. Hierzu ist zwischen den Speicherbehältern 12, 14 und der Rückhaltewanne 16 ein Aufnahmevolumen freigehalten, das groß genug ist das gesamte Flüssigkeitsvolumen sämtlicher vorgesehener Speicherbehälter 12, 14 aufnehmen zu können. Das Volumen der Speicherbehälter 12, 14 selbst kann dabei bis zu einer Überlaufkante mitgezählt werden. Die Speicherbehälter 12, 14 und/oder die Rückhaltewanne 16 kann von einem Isoliermaterial 18, insbesondere zur thermischen Isolierung und/oder flüssigkeitsdichten Abdichtung, umgeben sein. Die Speicherbehälter 12, 14 und die Rückhaltewanne 16 können aus einem Stahl hergestellt sein, wobei die Speicherbehälter 12, 14 bevorzugt aus einem Kunststoffmaterial hergestellt sind.

Die Rückhaltewanne 16 kann zusammen mit den eingesetzten Speicherbehältern 12, 14 in eine aus einem Stahl hergestellte Außenwanne 20, insbesondere vollständig, eingesetzt werden. Die Außenwanne 20 kann unterhalb der übrigen Ladestation unterirdisch im Erdreich eingegraben sein. Die Außenwanne 20 weist mehrere Versteifungsrippen 22 auf, damit die Außenwanne 20 die von dem umgebenen Erdreich aufgeprägten Lasten ertragen kann. Im Inneren der Außenwanne 20 ist auf dem Boden in Schwerkraftrichtung zwischen der Rückhaltewanne 16 und der Außenwanne 20 ein, insbesondere als textiles Vlies ausgestalteter Absorptionskörper 24 vorgesehen, der aus der Umgebung eindringende Feuchtigkeit und/oder als Leckage aus der Rückhaltewanne 16 austretendes Kühlfluid aufsaugen kann. Die in dem Absorptionskörper 24 angesammelte Feuchtigkeit kann von einem Feuchtigkeitssensor detektiert werden und in einer Auswerteeinheit ausgewertet werden, um zu entscheiden, ob eine zu reparierende Beschädigung der Außenwanne 20 und/oder der Rückhaltewanne 16 vorliegt. Der Feuchtigkeitssensor kann über ein nach oben herausstehendes Schaurohr 26 zugeführt werden, so dass der Feuchtigkeitssensor leicht überprüft und ausgetauscht werden kann. Über das Schaurohr 26 kann auch ein Endoskop eingeführt werden, um eine Sichtprüfung des Absorptionskörpers 24 durchzuführen. In einer weiteren Ausführungsform kann auch die Außenseite der Rückhaltewanne 16 und/oder die Innenseite der Außenwanne 20 mit dem Endoskop überprüft werden. Hierzu ist nur ein sehr schmaler Luftspalt zwischen der Rückhaltewanne 16 und der Außenwanne 20 erforderlich, so dass im Vergleich zu einer Aufständerung der Rückhaltewanne 16 in einer Betonschale ein deutlich geringerer Bauraumbedarf erreicht ist, der einen entsprechend geringeren Erdaushub erforderlich macht, um die Kühltankanlage 10 unterirdisch vorzusehen.

Gegebenenfalls weisen die Außenwanne 20 und/oder die Rückhaltewanne 16 eine Durchgangsöffnung 28 zum Durchführen eines doppelwandigen medienführenden Leitungsrohrs auf, das beispielsweise an einem Speicherbehälter 12, 14 angeschlossen ist und unterirdisch zu einer weiteren Ladestation oder Teilen und/oder Komponenten der Ladestation führt. Das Leitungsrohr kann über in den Durchgangsöffnungen 28 vorgesehene Ringraumdichtungen mit Gummipressdichtungen abgedichtet sein.

## Patentansprüche

1. Kühltankanlage für eine Flüssigkeitskühlung einer Ladestation für elektrisch antreibbare Kraftfahrzeuge, mit
mindestens einem Speicherbehälter (12, 14) zur Aufnahme eines umweltgefährdenden Kühlmediums,
einer Rückhaltewanne (16) zum Zurückhalten einer Leckagemenge aus dem Speicherbehälter (12, 14), wobei der Speicherbehälter (12, 14) in der Rückhaltewanne (16) eingesetzt ist und zwischen Speicherbehälter (12, 14) und der Rückhaltewanne (16) ein Aufnahmevolumen zur Aufnahme des gesamten Flüssigkeitsvolumens des Speicherbehälters (12, 14) ausgebildet ist,
einer Außenwanne (20) zur Abstützung von Erdlasten, wobei die Rückhaltewanne (16) in der Außenwanne (20) eingesetzt ist,
einem in Schwerkraftrichtung zwischen der Rückhaltewanne (16) und der Außenwanne (20) in der Außenwanne (20) vorgesehenen, insbesondere textilen, Absorptionskörper (24) zur Aufnahme von Feuchtigkeit und
einem Feuchtigkeitssensor zur Detektion der Feuchtigkeit des Absorptionskörpers (24).

2. Kühltankanlage nach Anspruch 1 **dadurch gekennzeichnet, dass** der Absorptionskörper (24) an einer in Schwerkraftrichtung tiefsten Stelle eines Innenraums der Außenwanne (20) und/oder über eine gesamte Bodenfläche der Außenwanne (20) vorgesehen ist.

3. Kühltankanlage nach Anspruch 1 oder 2 **dadurch gekennzeichnet, dass** die Außenwanne (20) aus einem Stahl hergestellt ist, wobei die Außenwanne (20) insbesondere Versteifungsrippen (22) zur Abstützung von Erdlasten aufweist.

4. Kühltankanlage nach einem der Ansprüche 1 und 3 **dadurch gekennzeichnet, dass** ein aus der Außenwanne (20) herausgeführtes Schaurohr (26) zur optischen Untersuchung des Absorptionskörpers (24) und/oder der Außenwanne (20) und/oder der Rückhaltewanne (16) an den Absorptionskörper (24) heranreicht, wobei der Feuchtigkeitssensor durch das Schaurohr (26) hindurch an den Absorptionskörper (24) herangeführt ist.

5. Kühltankanlage nach einem der Ansprüche 1 und 4 **dadurch gekennzeichnet, dass** der Speicherbehälter (12, 14) einen Füllstandssensor zur Detektion eines Füllstands des Kühlmediums in dem Speicherbehälter (12, 14) aufweist, wobei der Füllstandssensor mit einer Auswerteeinheit zum Vergleich des von dem Füllstandssensor gemessenen Füllstands mit einem ohne Leckage zu erwartenden Füllstand verbunden ist.

6. Kühltankanlage nach einem der Ansprüche 1 und 5 **dadurch gekennzeichnet, dass** in der Rückhaltewanne (16) ein weiterer Feuchtigkeitssensor und/oder ein weiterer Füllstandssensor zur Detektion einer Leckage aus dem Speicherbehälter (12, 14) in die Rückhaltewanne (16) vorgesehen ist.

7. Kühltankanlage nach einem der Ansprüche 1 und 6 **dadurch gekennzeichnet, dass** mit dem Speicherbehälter (12, 14) eine Zulaufleitung zur Zuführung von Kühlmedium an mindestens eine zu kühlende Komponente der Ladestation und eine Rücklaufleitung zur Rückführung vom von der zu kühlenden Komponente kommenden Kühlmedium vorgesehen ist, wobei zum Ausschluss einer hydraulischen Heberwirkung in der Zulaufleitung ein Entlüftungsventil und/oder in der Rücklaufleitung ein Rückschlagventil vorgesehen ist.

8. Kühltankanlage nach einem der Ansprüche 1 und 6 **dadurch gekennzeichnet, dass** in Schwerkraftrichtung oberhalb des Absorptionskörpers (24) ein durch die Außenwanne (20) und die Rückhaltewanne (16) hindurchgeführtes doppelwandiges medienführendes Leitungsrohr vorgesehen ist, wobei das Leitungsrohr über ein Dichtelement, insbesondere eine Ringraumdichtung und/oder einer Gummipressdichtung, gegenüber der Außenwanne (20) und der Rückhaltewanne (16) abgedichtet ist.

9. Kühltankanlage nach Anspruch 8 **dadurch gekennzeichnet, dass** eine mit dem Feuchtigkeitssensor verbundene Auswerteeinheit zur Identifikation und/oder Quantifizierung einer Leckage in der Außenwanne (20) und/oder in der Rückhaltewanne (16) vorgesehen ist, wobei das Leitungsrohr einen Leckagesensor zur Detektion einer Leckage in dem Leitungsrohr aufweist und der Leckagesensor mit der Auswerteeinheit zur Identifikation einer Leckage und/oder einer Quantifizierung einer Leckage in dem Leitungsrohr verbunden ist.

10. Ladestation zum Aufladen eines elektrisch antreibbaren Kraftfahrzeugs, mit einem Ladekabel zur Herstellung eines elektrischen Kontakts des Kraftfahrzeugs mit einer elektrischen Energiequelle, einer Leistungselektronik zur Steuerung eines Aufladevorgangs und einer Flüssigkeitskühleinrichtung zur Temperierung des Ladekabels und/oder der Leistungselektronik, wobei die Flüssigkeitskühleinrichtung eine zumindest zu einem Großteil unterirdisch vorgesehenen Kühltankanlage (10) nach einem der Ansprüche 1 bis 9 zur Speicherung eines Kühlmediums aufweist.

## Claims

1. Cooling tank installation for liquid cooling of a charging station for electrically driveable motor vehicles, comprising
at least one reservoir (12, 14) for receiving an environmentally hazardous cooling medium,
a retention vessel (16) for retaining a quantity of leakage from the reservoir (12, 14), wherein the reservoir (12, 14) is inserted in the retention vessel (16) and a receiving volume for receiving the entire liquid volume of the reservoir (12, 14) is formed between the reservoir (12, 14) and the retention vessel (16),
an outer vessel (20) for providing support with respect to earth loads, wherein the retention vessel (16) is inserted in the outer vessel (20),
an absorption body (24), in particular a textile absorption body, for absorbing moisture, provided in the outer vessel (20) between the retention vessel (16) and the outer vessel (20) in the direction of gravity, and
a moisture sensor for detecting the moisture of the absorption body (24).

2. Cooling tank installation according to Claim 1, **characterized in that** the absorption body (24) is provided at a lowest point in the direction of gravity of an interior space of the outer vessel (20) and/or over an entire bottom surface area of the outer vessel (20).

3. Cooling tank installation according to Claim 1 or 2, **characterized in that** the outer vessel (20) is produced from a steel, wherein the outer vessel (20) has in particular stiffening ribs (22) for providing support with respect to earth loads.

4. Cooling tank installation according to one of Claims 1 and 3, **characterized in that** a viewing tube (26), led out from the outer vessel (20), for visual examination of the absorption body (24) and/or the outer vessel (20) and/or the retention vessel (16) reaches up to the absorption body (24), wherein the moisture sensor is led up to the absorption body (24) through the viewing tube (26) .

5. Cooling tank installation according to one of Claims 1 and 4, **characterized in that** the reservoir (12, 14) has a filling-level sensor for detecting a filling level of the cooling medium in the reservoir (12, 14), wherein the filling-level sensor is connected to an evaluation unit for comparison of the filling level measured by the filling-level sensor with a filling level to be expected without leakage.

6. Cooling tank installation according to one of Claims 1 and 5, **characterized in that** a further moisture sensor and/or a further filling-level sensor for detecting a leakage from the reservoir (12, 14) into the retention vessel (16) is provided in the retention vessel (16).

7. Cooling tank installation according to one of Claims 1 and 6, **characterized in that** a supply line for feeding cooling medium to at least one component to be cooled of the charging station and a return line for returning cooling medium coming from the component to be cooled are provided with the reservoir (12, 14), wherein, to exclude the possibility of a hydraulic siphoning effect, a venting valve is provided in the supply line and/or a check valve is provided in the return line.

8. Cooling tank installation according to one of Claims 1 and 6, **characterized in that** a double-walled media-carrying pipe, led through the outer vessel (20) and the retention vessel (16), is provided above the absorption body (24) in the direction of gravity, wherein the pipe is sealed off with respect to the outer vessel (20) and the retention vessel (16) by way of a sealing element, in particular an annular-space seal and/or a rubber pressing seal.

9. Cooling tank installation according to Claim 8, **characterized in that** an evaluation unit connected to the moisture sensor is provided for the identification and/or quantification of a leakage in the outer vessel (20) and/or in the retention vessel (16), wherein the pipe has a leakage sensor for detecting a leakage in the pipe and the leakage sensor is connected to the evaluation unit for the identification of a leakage and/or a quantification of a leakage in the pipe.

10. Charging station for charging an electrically driveable motor vehicle, comprising a charging cable for establishing electrical contact of the motor vehicle with an electrical energy source, power electronics for controlling a charging operation and a liquid cooling device for adjusting the temperature of the charging cable and/or the power electronics, wherein the liquid cooling device has a cooling tank installation (10) according to one of Claims 1 to 9, which is at least largely provided underground, for storing a cooling medium.

## Revendications

1. Ensemble réservoir de refroidissement pour un refroidissement de liquide d'une station de charge pour véhicules électriques, comprenant
au moins un récipient de stockage (12, 14) servant à recevoir un milieu de refroidissement dangereux pour l'environnement,
une cuve de rétention (16) pour retenir une quantité de fuite provenant du récipient de stockage (12, 14), dans lequel le récipient de stockage (12, 14) est placé dans la cuve de rétention (16), et un volume de réception servant à recevoir le volume de liquide total du récipient de stockage (12, 14) est réalisé entre le récipient de stockage (12, 14) et la cuve de rétention (16),
une cuve extérieure (20) servant à supporter le poids de la terre, dans lequel la cuve de rétention (16) est placée dans la cuve extérieure (20),
un corps absorbant (24), en particulier textile, prévu dans la cuve extérieure (20), dans le sens de la gravité entre la cuve de rétention (16) et la cuve extérieure (20), servant à absorber l'humidité, et
un capteur d'humidité servant à détecter l'humidité du corps absorbant (24).

2. Ensemble réservoir de refroidissement selon la revendication 1, **caractérisé en ce que** le corps absorbant (24) est prévu à un point le plus bas dans le sens de la gravité d'un espace intérieur de la cuve extérieure (20) et/ou sur une surface de fond totale de la cuve extérieure (20) .

3. Ensemble réservoir de refroidissement selon la revendication 1 ou 2, **caractérisé en ce que** la cuve extérieure (20) est fabriquée en acier, dans lequel la cuve extérieure (20) présente en particulier des nervures de renforcement (22) pour supporter le poids de la terre.

4. Ensemble réservoir de refroidissement selon l'une quelconque des revendications 1 et 3, **caractérisé en ce qu'**un tuyau d'inspection (26) sorti de la cuve extérieure (20), servant au contrôle optique du corps absorbant (24) et/ou de la cuve extérieure (20) et/ou de la cuve de rétention (16), atteint le corps absorbant (24), dans lequel le capteur d'humidité est rapproché du corps absorbant (24) à travers le tuyau d'inspection (26).

5. Ensemble réservoir de refroidissement selon l'une quelconque des revendications 1 et 4, **caractérisé en ce que** le récipient de stockage (12, 14) présente un capteur de niveau de remplissage pour détecter un niveau de remplissage du milieu de refroidissement dans le récipient de stockage (12, 14), dans lequel le capteur de niveau de remplissage est relié à une unité d'évaluation pour comparer le niveau de remplissage mesuré par le capteur de niveau de remplissage avec un niveau de remplissage attendu sans fuite.

6. Ensemble réservoir de refroidissement selon l'une quelconque des revendications 1 et 5, **caractérisé en ce que** dans la cuve de rétention (16) un autre capteur d'humidité et/ou un autre capteur de niveau de remplissage est/sont prévu(s) pour la détection d'une fuite du récipient de stockage (12, 14) vers la cuve de rétention (16).

7. Ensemble réservoir de refroidissement selon l'une quelconque des revendications 1 et 6, **caractérisé en ce qu'**avec le récipient de stockage (12, 14), une conduite d'alimentation servant à alimenter le milieu de refroidissement à au moins un composant à refroidir de la station de charge est prévue et une conduite de retour pour récupérer le milieu de refroidissement provenant du composant à refroidir est prévue, dans lequel, afin d'exclure un effet de siphon hydraulique, une vanne de purge est prévue dans la conduite d'alimentation et/ou un clapet antiretour est prévu dans la conduite de retour.

8. Ensemble réservoir de refroidissement selon l'une quelconque des revendications 1 et 6, **caractérisé en ce que** dans le sens de la gravité, au-dessus du corps absorbant (24), un tuyau de conduite à double paroi, acheminant un milieu et traversant la cuve extérieure (20) et la cuve de rétention (16) est prévu, dans lequel le tuyau de conduite est rendu étanche par rapport à la cuve extérieure (20) et à la cuve de rétention (16) par un élément d'étanchéité, en particulier un joint d'espace annulaire et/ou un joint de compression en caoutchouc.

9. Ensemble réservoir de refroidissement selon la revendication 8, **caractérisé en ce qu'**une unité d'évaluation reliée au capteur d'humidité pour identifier et/ou quantifier une fuite dans la cuve extérieure (20) et/ou dans la cuve de rétention (16) est prévue, dans lequel le tuyau de conduite présente un capteur de fuite pour détecter une fuite dans le tuyau de conduite, et le capteur de fuite est relié à l'unité d'évaluation pour identifier une fuite et/ou quantifier une fuite dans le tuyau de conduite.

10. Station de charge servant à recharger un véhicule automobile électrique, comprenant un câble de charge pour établir un contact électrique entre le véhicule automobile et une source d'énergie électrique, une électronique de puissance pour commander un processus de charge et un dispositif de refroidissement de liquide pour réguler la température du câble de charge et/ou de l'électronique de puissance, dans lequel le dispositif de refroidissement de liquide présente un ensemble réservoir de refroidissement (10) selon l'une quelconque des revendications 1 à 9 pour stocker un milieu de refroidissement, prévu au moins en grande partie sous terre.
